# EUROPÄISCHE PATENTSCHRIFT

(11) **EP 3 017 667 B1**
(45) Veröffentlichungstag und Bekanntmachung des Hinweises auf die Patenterteilung: **18.03.2020**
(21) Anmeldenummer: 14735557.2
(22) Anmeldetag: 01.07.2014
(51) Int. Cl.: H05K 13/04, H05K 13/08, H05K 3/30

(54) **VERFAHREN ZUR BESTÜCKUNG ELEKTRONISCHER LEITERPLATTEN MIT OPTISCHEN BAUELEMENTEN.**
METHOD FOR FITTING OPTICAL COMPONENTS TO ELECTRONIC PRINTED CIRCUIT BOARDS
PROCÉDÉ POUR ÉQUIPER DES CARTES DE CIRCUITS IMPRIMÉS ÉLECTRONIQUES AVEC DES COMPOSANTS OPTIQUES

(30) Priorität: 05.07.2013 AT 504432013
(43) Veröffentlichungstag der Anmeldung: 11.05.2016
(73) Patentinhaber: MELECS EWS GmbH & Co KG, 7011 Siegendorf (AT)
(72) Erfinder: EGGER, Rainer, A-1220 Wien (AT); HELLINGER, Leopold, A-3710 Ziersdorf (AT); NEUMANN, Gerhard, A-3231 St. Margarethen (AT)
(74) Vertreter: Maier, Daniel Oliver
(86) Internationale Anmeldenummer: PCT/EP2014/063951
(87) Internationale Veröffentlichungsnummer: WO 2015/000894

(56) Entgegenhaltungen:
- EP-A1- 2 295 850
- WO-A1-2014/153576
- WO-A2-2009/037634
- JP-A- 2011 128 290
- US-A1- 2010 053 929
- US-A1- 2011 293 168

## Beschreibung

Die Erfindung betrifft ein Verfahren zur Bestückung elektronischer Leiterplatten mit optischen Bauelementen.

Bei einer Bestückung von Bauelementeträgern (z.B. Leiterplatten) mit Bauelementen werden so genannte Bestückautomaten eingesetzt. Die Bauelemente werden dabei üblicherweise von einer Bauelemente-Zuführeinrichtung an bestimmten Abholpositionen bereitgestellt und von dort von einem Bestückkopf abgeholt. Der Bestückkopf kann mittels eines Positioniersystems innerhalb eines Arbeitsbereichs frei positioniert werden. Nach dem Abholen werden die Bauelemente vom Bestücckopf zu einer Bestückposition transportiert und auf dem zu bestückenden Bauelementträger an vorgegebenen Einbaupositionen aufgesetzt, welche durch entsprechende elektrische Anschlussflächen definiert sind.

Aufgrund der zunehmenden Miniaturisierung von elektronischen Bauelementen ist ein präziser Bestückvorgang nur durch eine genaue Vermessung und Inspektion der vom Bestückkopf aufgenommenen Objekte bzw. Bauelemente möglich. Dabei weisen die Objekte bzw. Bauelemente Merkmale bzw. Merkmalsgruppen (z.B. Ecken, Kanten, Bauelementanschlüsse, Zentrierstifte, Markierungen, etc.) auf, von welchen Aufschluss über Typ und Lage bzw. Position des Bauelements gegeben wird.

Für ein Vermessung und Inspektion von Objekten, insbesondere Bauelementen, in Bestückautomaten werden üblicherweise Bildverarbeitungssysteme eingesetzt. Dabei wird zum Vermessen und Inspizieren das Objekt bzw. das elektronische Bauelement, das von einem Bestückkopf aufgenommen wurde, vom Bestückkopf oder von einer entsprechenden Haltevorrichtung relativ zu einer Kamera (z.B. Bauelement-Kamera) des Bildverarbeitungssystems derart positioniert, dass sich das zu vermessenden und inspizierende Objekt im Gesichtsfeld der Kamera befindet. Die eigentliche Vermessung und Inspektion - und damit auch das Erkennen des Objekts bzw. Bauelements sowie seiner Position - erfolgt dann mittels Bildverarbeitungsprozessen durch das Bildverarbeitungssystem. Eine beispielhafte Einrichtung zur Montage elektronischer Bauteile ist aus der EP 1282350 B1 bekannt.

Aus der US 2011/293168 ist ein Verfahren zur Montage von transparenten Bauteilen bekannt, bei dem mittels gezielter Beleuchtung die Erfassung der transparenten Bauteile mittels Bildverarbeitungssystem verbessert werden soll.

Die WO 2009/037634 A2 beschreibt ein LED-Modul mit optischem Lichtleitelement und elektrischen Komponenten welches zur leichteren Montage eine optisch detektierbare Referenzmarke aufweist.

Aus der US 2010/053929 ist eine Methode zur Herstellung eines LED-Modules bekannt, bei dem mit leitfähigem Epoxidharz leitfähige Verbindungen hergestellt werden.

Die JP 20111128290 offenbart ein kostengünstiges Montageverfahren eines Leuchtelements auf einem Substrat.

Aus der EP 2295850 ist ein Beleuchtungsmodul für Automobile bekannt, welches neben einer Leuchtdiode auch einen elliptischen Reflektor und eine Leiterplatte umfasst.

Die bekannten Vorgehensweisen führen insbesondere bei der Bestückung optischer Bauelemente zu unbefriedigenden Ergebnissen, da beispielsweise bei Leuchtdioden in SMD-Bauweise die Licht-abstrahlende Fläche keine exakt vorhersagbare Position innerhalb des Gehäuses aufweist. Die Positionierung anhand der Gehäuseabmessungen ist daher nicht präzise genug. Dies insbesondere auch, wenn die optischen Eigenschaften eines Gesamtsystems von einer Mehrzahl von Komponenten wie Leuchtdioden und Reflektoren bestimmt werden.

Der Erfindung liegt daher die Aufgabe zugrunde, die Positionierung von optischen Bauelementen zu verbessern.

Erfindungsgemäß geschieht dies mit einem Verfahren gemäß Anspruch 1.

Vorteilhafte Ausgestaltungen ergeben sich aus den Unteransprüchen.

Die Erfindung wird anhand eines Ausführungsbeispieles näher erläutert, welches in schematischer Weise den Ablauf des erfindungsgemäßen Verfahrens bei der Montage eines Scheinwerfers zeigt.

Zur weiteren Veranschaulichung dienen die Figuren. Es zeigen
- Fig. 1: schematisch eine Leuchtdiode in SMD Bauweise und
- Fig.2: schematisch den Aufbau eines Scheinwerfers.

Dieser Schweinwerfer umfasst neben einer Leiterplatte 5 als Basiskörper zumindest eine Leuchtdiode in SMD-Bauweise 1 und einen oder mehrere Reflektoren 6, sowie gegebenenfalls auch hier nicht dargestellte Linsensysteme. Für die optische Funktionsweise ist die präzise Anordnung von Leuchtdioden 1 und Reflektoren 6 zueinander von wesentlicher Bedeutung. Fehler in der Positionierung der einzelnen Bauelemente können sich in einem worst-case-Szenario summieren und so unzulässige Werte annehmen.

Erfindungsgemäß erfolgt nun eine präzise Ausrichtung der optischen Bauelemente durch mehrere Maßnahmen:
So wird die exakte Position der Licht-abstrahlenden Fläche 2 innerhalb des Gehäuses der Leuchtdioden in SMD-Bauweise 1 bestimmt und daraus ein erster Korrekturfaktor berechnet. Diese Bestimmung erfolgt bereits vor dem eigentlichen Bestückungsvorgang mit einem eigenen Kamerasystem, während sich die Leuchtdioden noch in der Bauelemente-Zuführeinrichtung, z.B. einem Zuführgurt befinden.

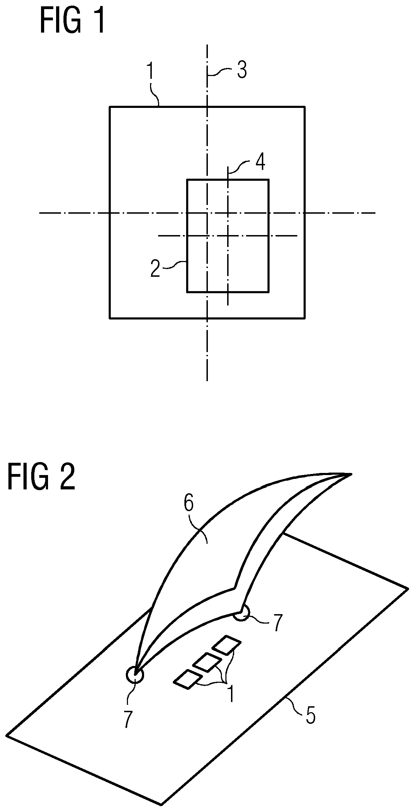

In Fig. 1 ist diese Position der Licht-abstrahlenden Fläche 2 innerhalb des Gehäuses der Leuchtdioden in SMD-Bauweise 1 durch ein zweites geometrisches Achsenkreuz 4 der Licht-abstrahlenden Fläche dargestellt. Dieses zweite Achsenkreuz 4 zeigt das optisch maßgebliche Zentrum der Leuchtdiode 1 an. Dieses optische Zentrum stimmt nicht überein mit dem durch das erste geometrische Achsenkreuz 3 der Leuchtdiode definierte geometrische Zentrum der Leuchtdiode 1. Die Abweichung zwischen den beiden Achsenkreuzen 3,4 wird mittels erstem Korrekturfaktor, einem zweidimensionalen Vektor erfasst.

Weiterhin werden Referenzpunkten für weitere optische Bauelemente ermittelt und diese vermessen. Als weitere Referenzpunkte eigenen sich in besonderer Weise Bohrungen 7 in der Leiterplatte 5, die für die Befestigung der Reflektoren 6 oder von Linsensystemen vorgesehen sind.

Aus den Maßen für die weiteren Referenzpunkte, d.h. den für die Reflektoren 6 vorgesehenen Bohrungen 7 wird zumindest ein weiterer Korrekturfaktor berechnet.

Dabei ist anzumerken, dass die Korrekturfaktoren zweidimensionale Vektoren darstellen, welche eine Korrektur sowohl in x-Richtung als auch in y-Richtung eines in der Ebene der Leiterplatte angeordneten Koordinatensystems beinhalten.

Durch diesen direkten Bezug zu den für die Reflektoren 6 vorgesehenen Bohrungen 7 wird eine mögliche Kettenfehlerbildung vermieden und die Genauigkeit der Bestückung weiter erhöht.

An der solcherart ermittelten tatsächlichen Einbauposition werden schlußendlich die Leuchtdioden in SMD-Bauweise 1 aufgesetzt.

Nach dem Bestücken der weiteren vorgesehenen Bauelemente 6 wie ggf. weiterer, für die Steuerung des Scheinwerfers vorgesehener elektronischer Komponenten, wird mit bekannten geeigneten Verfahren gelötet oder ein Leitklebeverfahren angewendet.

### Bezugszeichen

- 1: Leuchtdiode in SMD Bauweise
- 2: Licht-abstrahlende Fläche
- 3: erstes geometrisches Achsenkreuz der Leuchtdiode
- 4: zweites geometrisches Achsenkreuz der Lichtabstrahlenden Fläche
- 5: Leiterplatte
- 6: Reflektor
- 7: Bohrungen für Reflektor

## Patentansprüche

1. Verfahren zur Bestückung elektronischer Leiterplatten (5) mit Leuchtdioden in SMD-Bauweise, wobei die Leuchtdioden(1)mittels Bildverarbeitungssystemen vermessen und positioniert werden, mit folgenden Verfahrensschritten:
- die Leuchtdioden (1)werden vor dem eigentlichen Bestückungsvorgang, vorzugsweise im Zuführgurt vermessen und die Position (4) der optisch maßgeblichen Elemente (2) in Bezug zum Gesamtbauelement (1) ermittelt und daraus ein erster Korrekturfaktor berechnet,
- in der Leiterplatte (5)vorhandene Referenzpunkte (7) für weitere optische Bauelemente (6) werden ermittelt und vermessen,
- aus den Referenzpunkten (7) für weitere optische Bauelemente (6)wird zumindest ein weiterer Korrekturfaktor berechnet,
- beim Bestückungsvorgang werden die vorgegebenen Einbaupositionen mit den Korrekturfaktoren korrigiert und eine tatsächliche Einbauposition ermittelt,
- die Leuchtdioden (1) werden an der tatsächlichen Einbauposition aufgesetzt,
- wobei es sich bei den weiteren optischen Bauelementen (6) um Reflektoren und/oder Linsensysteme handelt.

2. Verfahren nach Anspruch 1, **dadurch gekennzeichnet, dass** als in der Leiterplatte (5) vorhandene Referenzpunkte für weitere optische Bauelemente (6) Bohrungen (7) zur Befestigung von Reflektoren und/oder Linsensystemen herangezogen werden.

## Claims

1. Method for fitting light-emitting diodes to electronic printed circuit boards (5) in an SMD construction, wherein the light-emitting diodes (1) are measured and positioned by means of image processing systems, having the following method steps:
- the light-emitting diodes (1) are measured before the actual fitting procedure, preferably in the feeding belt and the position (4) of the optically significant elements (2) in respect of the overall component (1) is determined and a first correction factor is calculated therefrom,
- reference points (7) available in the printed circuit board (5) are determined and measured for further optical components (6),
- at least one further correction factor is calculated from the reference points (7) for further optical components (6),
- during the fitting procedure, the predetermined mounting positions are corrected with the correction factors and an actual mounting position is determined,
- the light-emitting diodes (2) are attached at the actual mounting position,
- wherein the further optical components (6) are reflectors and/or lens systems.

2. Method according to claim 1, **characterised in that** drilled holes (7) for fastening reflectors and/or lens systems are used as reference points, for further optical components (6), available in the printed circuit boards.

## Revendications

1. Procédé pour équiper des cartes de circuits imprimés électroniques (5) avec des diodes luminescentes de type SMD, dans lequel les diodes luminescentes (1) sont dimensionnées et positionnées au moyen de systèmes de traitement d'image, comprenant les étapes de procédé suivantes :
- les diodes luminescentes (1) sont dimensionnées avant l'opération d'équipement en soit, de préférence dans la courroie de transport, et la position (4) des éléments (2) optiques déterminants est déterminée par rapport à l'élément de construction général (1) et un premier facteur de correction est calculé à partir de cela,
- des points de référence (7) présents dans le circuit imprimé (5) sont déterminés et dimensionnés pour d'autres éléments de construction optiques (6),
- au moins un autre facteur de correction est calculé à partir des points de référence (7) pour d'autres éléments de construction optiques (6),
- lors de l'opération d'équipement, les positions d'intégration prédéfinies sont corrigées avec les facteurs de correction et une position d'intégration effective est déterminée,
- les diodes luminescentes (1) sont placées à la position d'intégration effective,
- dans lequel les autres éléments de construction optiques (6) sont des réflecteurs et/ou des systèmes de lentilles.

2. Procédé selon la revendication 1, **caractérisé en ce que** des perçages (7) pour fixer des réflecteurs et/ou des systèmes de lentilles sont utilisés en tant que points de référence pour d'autres éléments de construction optiques (6) présents dans le circuit imprimé (5).
